# EUROPEAN PATENT APPLICATION

(11) **EP 4 701 396 A1**
(43) Date of publication of application: **25.02.2026**
(21) Application number: 24806206.9
(22) Date of filing: 29.03.2024
(51) Int. Cl.: H10N 97/00

(54) **DIE, CHIP, AND ELECTRONIC DEVICE**

(30) Priority: 12.05.2023 CN 202310543958
(71) Applicant: Huawei Technologies Co., Ltd., Shenzhen, Guangdong 518129 (CN)
(72) Inventor: SUN, Yiping, Shenzhen, Guangdong 518129 (CN); PAN, Yinghua, Shenzhen, Guangdong 518129 (CN); YU, Xueming, Shenzhen, Guangdong 518129 (CN); GAO, Jiliang, Shenzhen, Guangdong 518129 (CN)
(74) Representative: Maiwald GmbH
(86) International application number: PCT/CN2024/084963
(87) International publication number: WO 2024/234846

(57) **Abstract**

This application relates to the field of chip technologies, and discloses a die, a chip, and an electronic device. The die includes a substrate, and a first bus signal board, a first metal plate, and a transistor that are stacked on the substrate. The first bus signal board and the first metal plate are spaced apart in a first direction, and the first direction is a thickness direction of the substrate. In the first direction, a projection region of the first bus signal board on the substrate is a first projection region, a projection region of the first metal plate on the substrate is a second projection region, and the first projection region and the second projection region at least partially overlap. In the first direction, a projection region of the transistor on the substrate is a third projection region, and the third projection region and the first projection region are spaced apart from each other. The first bus signal board and the first metal plate are separately connected to pins of the transistor. A layout of a circuit inside the die is properly designed, thereby effectively improving a space utilization rate of the die, and reducing manufacturing costs.

## Description

This application claims priority to Chinese Patent Application No. 202310543958.4, filed with the China National Intellectual Property Administration on May 12, 2023 and entitled "DIE, CHIP, AND ELECTRONIC DEVICE", which is incorporated herein by reference in its entirety.

### TECHNICAL FIELD

This application relates to the field of chip technologies, and in particular, to a die, a chip, and an electronic device.

### BACKGROUND

With the development of science and technologies, chips are increasingly widely used. Currently, a chip usually includes both a die (die) and a passive component, to meet use requirements in different scenarios. For example, in addition to a die configured to implement an amplification function, a capacitor or an inductor may be further arranged in a power amplifier (power amplifier, PA) chip, to form a matching circuit configured to adjust impedance (such as fundamental impedance (fundamental impedance, Z_f0) or harmonic impedance). However, an existing layout solution of the die and the passive component occupies a large area, has a low space utilization rate, and is not conducive to implementing a compact design.

### SUMMARY

To resolve the foregoing technical problems, this application provides a die, a chip, and an electronic device. A layout of a circuit inside the die is properly designed, to effectively avoid that a passive component additionally occupies an area of the die, thereby improving a space utilization rate of the die, and reducing manufacturing costs.

According to a first aspect, this application provides a die. The die includes a substrate, and a first bus signal board, a first metal plate, and a transistor that are stacked on the substrate. The first bus signal board and the first metal plate are spaced apart in a first direction, and the first direction is a thickness direction of the substrate. In the first direction, a projection region of the first bus signal board on the substrate is a first projection region, a projection region of the first metal plate on the substrate is a second projection region, and the first projection region and the second projection region at least partially overlap. In the first direction, a projection region of the transistor on the substrate is a third projection region, and the third projection region and the first projection region are spaced apart from each other. The first bus signal board and the first metal plate are separately connected to pins of the transistor.

According to an implementation of this application, the first bus signal board and the first metal plate in the die may jointly form a capacitor. A layout of the first bus signal board and the first metal plate is properly designed, so that area reusing is also implemented between the first bus signal board and the first metal plate when a circuit design requirement is met, to effectively avoid that the capacitor occupies an extra area of the substrate, and reduce an unnecessary component, thereby improving a space utilization rate of the die, and reducing manufacturing costs of the die.

In a possible implementation of the first aspect, the second projection region is located in the first projection region, to further reduce an area occupied by the first metal plate, thereby improving the space utilization rate.

In a possible implementation of the first aspect, a dielectric layer is arranged between the first bus signal board and the first metal plate in the first direction.

According to this implementation of this application, the first bus signal board and the first metal plate may jointly form the capacitor, and different capacitance values may be designed by adjusting a thickness of the dielectric layer, to adapt to different application scenarios, and expand an application scope.

In a possible implementation of the first aspect, the dielectric layer includes silicon nitride or aluminum oxide.

In a possible implementation of the first aspect, the first metal plate and the transistor are located on a same surface of the substrate, and the first bus signal board is located on a side that is of the first metal plate and that faces away from the substrate.

Based on this, the first metal plate and the transistor can also be conveniently manufactured on the substrate at a time when it is ensured that the first bus signal board and the first metal plate can jointly form the capacitor, thereby effectively reducing molding difficulty and manufacturing costs of the first metal plate and the transistor.

In a possible implementation of the first aspect, the transistor is a field-effect transistor.

In a possible implementation of the first aspect, the first bus signal board is an input bus signal board, and the input bus signal board is connected to a gate finger of the transistor. The transistor includes at least one source region, the at least one source region includes a first source region, and the first metal plate is connected to the first source region through a first metal trace.

In a possible implementation of the first aspect, the first metal plate and the transistor are spaced apart in a second direction, and the second direction is perpendicular to the first direction. The first source region extends in the second direction, and a projection of the first metal trace and a projection of the first source region at least partially overlap in the second direction.

Area reusing may be implemented between the first metal trace and the first source region, to effectively avoid that the first metal trace occupies an excessive area, thereby further improving the space utilization rate, and reducing the manufacturing costs.

In a possible implementation of the first aspect, the first metal trace extends in the second direction, the projection of the first metal trace is located in the projection of the first source region in the second direction, a projection of the first metal trace and a projection of the first source region at least partially overlap in a third direction, and the third direction is perpendicular to both the first direction and the second direction.

Area reusing may be implemented between the first metal trace and the first source region, to effectively avoid that the first metal trace occupies the excessive area, thereby further improving the space utilization rate, and reducing the manufacturing costs.

In a possible implementation of the first aspect, the at least one source region includes a second source region, and the first metal plate is connected to the second source region through a second metal trace. The second source region extends in the second direction, and the second source region and the first source region are spaced apart in the third direction. A projection of the second metal trace and a projection of the second source region at least partially overlap in the second direction, and a projection of the second metal trace and a projection of the second source region at least partially overlap in the third direction.

Area reusing may be implemented between the second metal trace and the second source region, to effectively avoid that the second metal trace occupies an excessive area, thereby further improving the space utilization rate, and reducing the manufacturing costs.

In a possible implementation of the first aspect, each of the at least one source region is grounded.

In a possible implementation of the first aspect, there are a plurality of gate fingers of the transistor, the plurality of gate fingers extend in a second direction, the plurality of gate fingers are spaced apart in a third direction, the first direction, the second direction, and the third direction are perpendicular to each other, and the plurality of gate fingers are separately connected to the first bus signal board. Projections of the plurality of gate fingers are located in a projection of the first metal plate in the second direction.

According to this implementation of this application, there are the plurality of gate fingers, to meet a use requirement in a high-power scenario, thereby further expanding the application scope. In addition, a distance between the capacitor including the first bus signal board and the first metal plate and the plurality of gate fingers is not excessively long, so that a working effect of the capacitor is better.

In a possible implementation of the first aspect, the die further includes an output bus signal board, and the output bus signal board is connected to a drain finger of the transistor.

According to a second aspect, this application provides a chip. The chip includes a base board and any die in the first aspect and the possible implementations of the first aspect. The die is arranged on the base board.

According to the chip, a required circuit may be formed by using a passive component inside the die, to effectively reduce an unnecessary electronic component, improve a space utilization rate inside the chip, reduce manufacturing costs, and reduce parasitic inductance inside the chip, thereby further improving working performance of the chip.

In a possible implementation of the second aspect, the chip is a power amplifier chip.

According to a third aspect, this application provides an electronic device. The electronic device includes a housing and any chip in the second aspect and the possible implementation of the second aspect. The chip is arranged in the housing.

### BRIEF DESCRIPTION OF DRAWINGS

FIG. 1A is a three-dimensional diagram of an electronic device according to an embodiment of this application;
FIG. 1B is an exploded view of an electronic device according to an embodiment of this application;
FIG. 2 is a diagram of a relationship between a phase of secondary harmonic impedance and efficiency of a chip according to an embodiment of this application;
FIG. 3 is a diagram of a structure of a chip in some technical solutions;
FIG. 4 is a diagram of a structure of a die in a chip in some technical solutions;
FIG. 5 is a circuit diagram of a matching circuit in a chip in some technical solutions;
FIG. 6 is a diagram of a structure of a die in some other technical solutions;
FIG. 7A is a top view of a die according to an embodiment of this application;
FIG. 7B is a sectional view of a die according to an embodiment of this application;
FIG. 8A is a top view of a die when a first metal trace in the die is equivalent to an inductor according to some embodiments of this application;
FIG. 8B is a sectional view of a die when a first metal trace in the die is equivalent to an inductor according to some embodiments of this application;
FIG. 9 is a circuit diagram of a second matching circuit including an inductor and a capacitor in a die according to an embodiment of this application;
FIG. 10A shows an example arrangement manner 1 of a first metal trace according to some embodiments of this application;
FIG. 10B shows an example arrangement manner 2 of a first metal trace according to some embodiments of this application; and
FIG. 11 is a diagram of a structure of a chip including a die according to some embodiments of this application.

Reference numerals: 1-electronic device; 10-chip; 100-die; 110-substrate; 120-first bus signal board; 130-first metal plate; 140-transistor; 141-gate finger; 142-source region; 1421-ground hole; 142'-first source region; 142"-second source region; 142"'-third source region; 142""-fourth source region; 143-drain finger; 150-dielectric layer; 160-metal trace; 161-first metal trace; 162-second metal trace; 163-third metal trace; 164-fourth metal trace; 170-second bus signal board; 10a-chip; 100a-die; 110a-substrate; 120a-first bus signal board; 130a-second bus signal board; 140a-transistor; 141a-gate finger; 142a-source region; 1421a-ground hole; 143a-drain finger; 100b-die; 110b-substrate; 120b-first bus signal board; 130b-second bus signal board; 140b-transistor; 141b-gate finger; 142b-source region; 143b-drain finger; 150b-first plate; 160b-second plate; 170b-metal trace; 20-display screen; 30-housing; 40-accommodating space; S1-first projection region; S2-second projection region; S3-third projection region; S4-first part of the first metal trace; C1-capacitor; C2-capacitor; L1-inductor; L2-inductor; L3-inductor; h0-central axis of the first source region; M1-first matching circuit; and M2-second matching circuit.

### DESCRIPTION OF EMBODIMENTS

To make objectives, technical solutions, and advantages of this application clearer, the following further describes implementations of this application in detail with reference to accompanying drawings.

This application provides a die, a chip including the die, and an electronic device. The die provided in embodiments of this application includes a passive component. A layout of a circuit inside the die is properly designed, to avoid that the passive component occupies an extra area of the die, thereby effectively improving a space utilization rate of the die, and reducing manufacturing costs.

It may be understood that, the electronic device provided in this application may be, but is not limited to, any one of electronic devices having a chip, such as a base station device, a mobile phone, a tablet computer, a notebook computer, a wearable device, a super netbook, a mobile personal computer (ultra-mobile personal computer, UMPC), and a personal digital assistant (personal digital assistant, PDA). The chip may be, but is not limited to, any one of chips such as a power amplifier chip, a baseband chip, a power management integrated chip (Power Management IC, PMIC), a central processing unit (Central Processing Unit/Processor, CPU) chip, and a system-on-chip (System-on-Chip, SoC). For ease of description, the following describes this application by using an example in which the chip is the power amplifier chip.

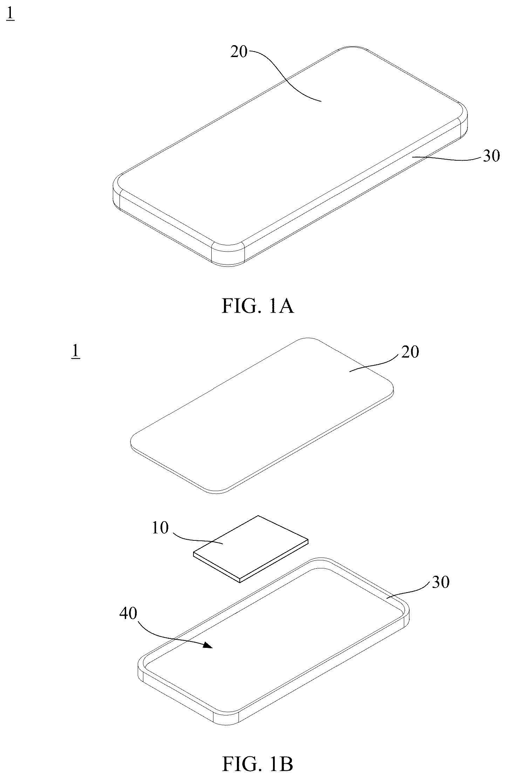

FIG. 1A and FIG. 1B are diagrams of an electronic device 1 according to an embodiment of this application. FIG. 1A is a three-dimensional diagram of the electronic device 1, and FIG. 1B is an exploded diagram of the electronic device 1. Refer to FIG. 1A and FIG. 1B. The electronic device 1 includes a chip 10, a display screen 20, and a housing 30. The display screen 20 and the housing 30 may jointly enclose an accommodating space 40. The chip 10 is located in the accommodating space 40.

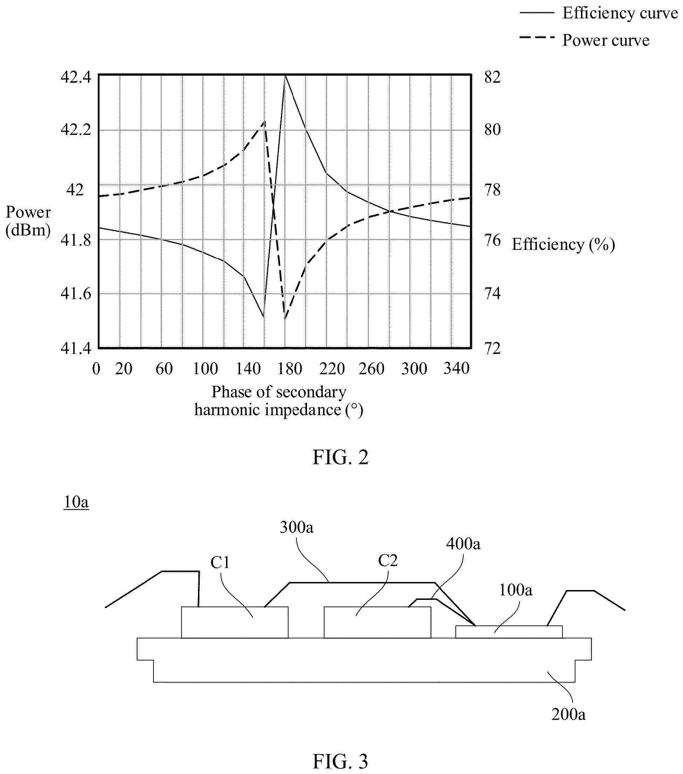

The chip 10 may include a die (not shown in the figure) and a passive component (not shown in the figure). The die may be configured to implement an amplification function of the chip 10. The passive component may be configured to form various circuits. For example, a capacitor or an inductor may form a matching circuit to adjust impedance, thereby improving performance of the chip 10, and reducing energy consumption. For example, FIG. 2 is a diagram of a relationship between a phase of secondary harmonic impedance and efficiency of the chip 10 according to an embodiment of this application. As shown in FIG. 2, the phase of the secondary harmonic impedance (secondary harmonic impedance, Z_h2) may be adjusted to 180° (that is, the secondary harmonic impedance is close to 0 hm (short circuit)) by using a matching circuit. In this case, the efficiency (shown by a solid line in FIG. 2) of the chip 10 may reach a maximum value of about 82%, thereby effectively reducing energy consumption. For another example, the phase of the secondary harmonic impedance may alternatively be adjusted to 160° by using the matching circuit. In this case, a power (shown by a dashed line in FIG. 2) of the chip 10 may reach a maximum value of about 42.22 dBm.

The following describes an example structure and a layout solution of the die and the passive component in the chip with reference to the accompanying drawings.

In some technical solutions, the passive component in the chip may be arranged outside the die. FIG. 3 is a diagram of a structure of a chip 10a in some technical solutions. As shown in FIG. 3, the chip 10a includes a die 100a, a capacitor C1, a capacitor C2, and a base board 200a. The die 100a, the capacitor C1, and the capacitor C2 each are arranged on the base board 200a.

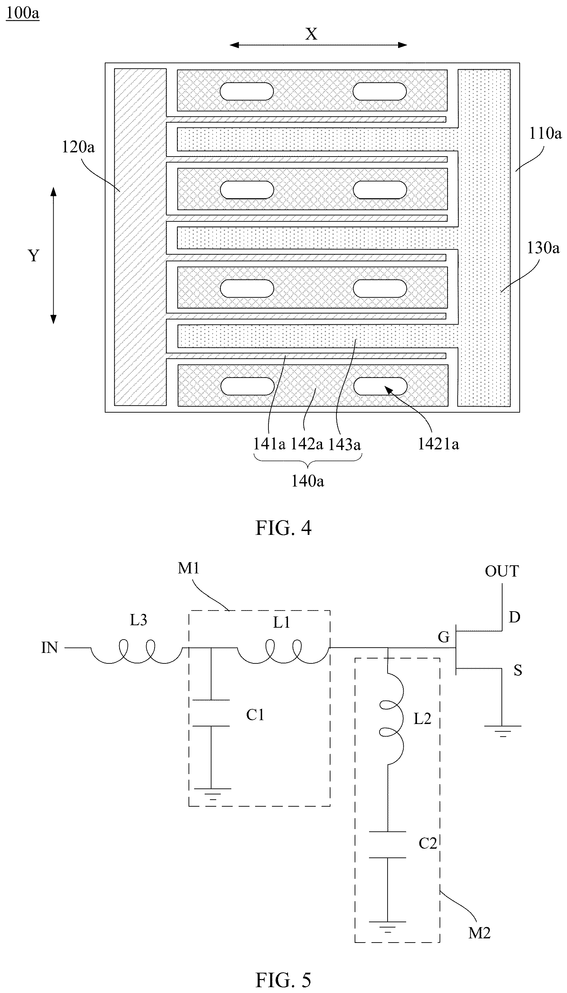

Specifically, FIG. 4 is a diagram of a structure of the die 100a in the chip 10a in some technical solutions. Refer to FIG. 4. The die 100a may include a substrate 110a, and a first bus signal board 120a, a second bus signal board 130a, and a transistor 140a that are arranged on the substrate 110a.

The transistor 140a includes a plurality of gate fingers 141a, a plurality of source regions 142a, and a plurality of drain fingers 143a. The gate finger 141a is a metal finger of a gate. The source region 142a is a metal strip of a source. The drain finger 143a is a metal finger of a drain. The plurality of gate fingers 141a, the plurality of source regions 142a, and the plurality of drain fingers 143a extend in an X-axis direction (or referred to as a "second direction"). In addition, in a Y-axis direction (or referred to as a "third direction"), the plurality of source regions 142a and the plurality of drain fingers 143a are alternately arranged, and each gate finger 141a is located between a source region 142a and a drain finger 143a that are in one group and that are adjacent to the gate finger 141a. For example, the X-axis direction and the Y-axis direction are perpendicular to each other.

The plurality of gate fingers 141a are separately connected to the first bus signal board 120a. An input end signal may be split to the gate fingers 141a through the first bus signal board 120a. The plurality of source regions 142a are grounded through ground holes 1421a. The plurality of drain fingers 143a are separately connected to the second bus signal board 130a, and signals on the plurality of drain fingers 143a can be combined to the second bus signal board 130a and can be output. When an appropriate voltage is applied between the gate finger 141a and the source region 142a, a current is generated on the drain finger 143a. In addition, a large current can be driven by using only a small voltage, to implement the amplification function of the chip 10a.

The capacitor C1 is connected to the die 100a through a bonding wire (bonding wire, BW) 300a, and the capacitor C2 is connected to the die 100a through a bonding wire 400a, to form a matching circuit of the chip 10a.

FIG. 5 is a circuit diagram of a matching circuit in the chip 10a in some technical solutions. Refer to FIG. 3 to FIG. 5. The chip 10a may include a first matching circuit M1 and a second matching circuit M2. The first matching circuit M1 includes the capacitor C1 and an inductor L1 (that is, the bonding wire 300a shown in FIG. 3), and may be configured to adjust fundamental impedance. The second matching circuit M2 includes the capacitor C2 and an inductor L2 (that is, the bonding wire 400a shown in FIG. 3), and may be configured to adjust secondary harmonic impedance.

Specifically, an input end IN is connected to a first end of the inductor L1 through an inductor L3. A second end of the inductor L1 is connected to a gate G of the die 100a. A source S of the die 100a is grounded. A drain D of the die 100a is connected to an output end OUT. A first end of the capacitor C1 is grounded, and a second end of the capacitor C1 is connected between the inductor L1 and the inductor L3, to form the first matching circuit M1 with the inductor L1. A first end of the capacitor C2 is grounded, and a second end of the capacitor C2 is connected between the inductor L1 and the gate G through the inductor L2, to form the second matching circuit M2 with the inductor L2.

It is not difficult to find based on the structure of the chip 10a that, the passive component (for example, the capacitor C1, the capacitor C2, the inductor L1, or the inductor L2) is arranged outside the die 100a, and additionally occupies an area of the base board 200a, resulting in a low space utilization rate, and increasing manufacturing costs.

In some other technical solutions, the die uses a monolithic microwave integrated circuit (Monolithic Microwave Integrated Circuit, MMIC) design, and the passive component may be integrated inside the die.

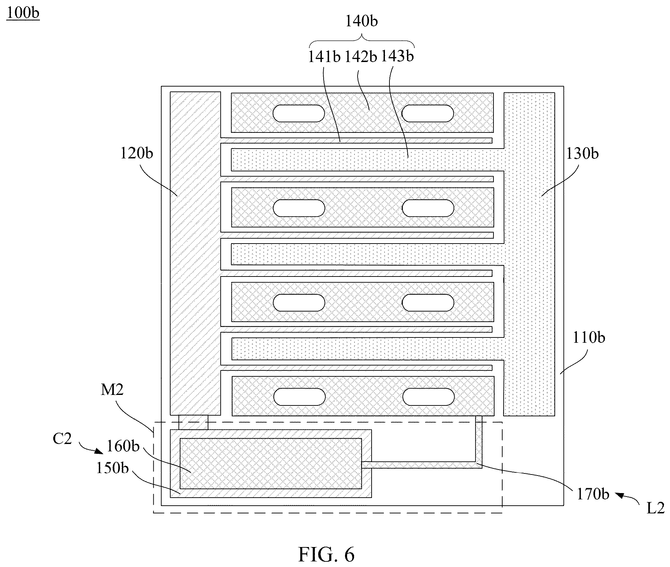

FIG. 6 is a diagram of a structure of a die 100b in some other technical solutions. As shown in FIG. 6, the die 100b includes a substrate 110b, and a first bus signal board 120b, a second bus signal board 130b, a transistor 140b, a capacitor C2, and an inductor L2 that are arranged on the substrate 110b.

Specific structures and connection manners of the first bus signal board 120b, the second bus signal board 130b, and the transistor 140b are consistent with specific structures and connection manners of the first bus signal board 120a, the second bus signal board 130a, and the transistor 140a in the die 100a. For details, refer to FIG. 4 and related descriptions thereof. Details are not described herein again.

The capacitor C2 includes a first plate 150b and a second plate 160b. The first plate 150b is connected to the first bus signal board 120b. The second plate 160b is connected to one source region 142b in the transistor 140b through a metal trace 170b. The metal trace 170b may be equivalent to the inductor L2. In this way, the capacitor C2 and the inductor L2 may form a second matching circuit M2. In other words, the second matching circuit M2 is integrated inside the die 100b.

In comparison with FIG. 4 and FIG. 6, the second matching circuit M2 integrated inside the die 100b additionally occupies the area of the substrate 110b. Compared with the die 100a inside which the second matching circuit M2 is not arranged, the die 100b has a larger overall area, and is not conducive to implementing a compact design. In addition, a semiconductor material (for example, gallium nitride (Gallium nitride, GaN)) used by the die 100b is usually expensive. Therefore, an increase in the area of the die 100b further causes higher manufacturing costs.

To resolve the foregoing problems, this application provides a die. The die includes a passive component. A layout of a circuit inside the die is properly designed, so that an unnecessary area waste can be effectively reduced when a circuit design requirement is met, thereby further improving a space utilization rate of the die, and reducing manufacturing costs. The following provides detailed descriptions with reference to the accompanying drawings.

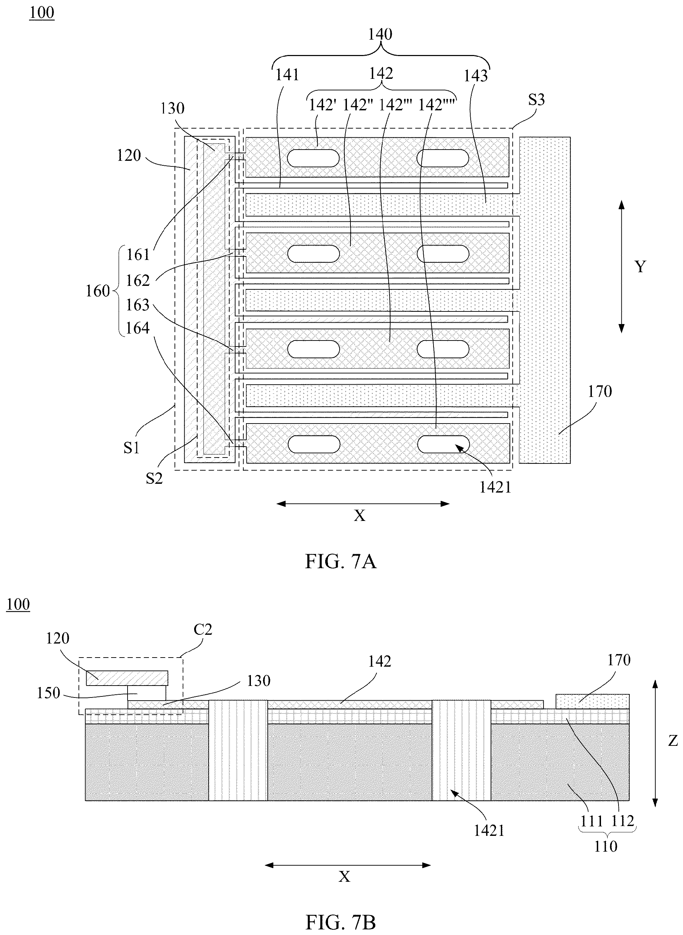

FIG. 7A and FIG. 7B are diagrams of a structure of a die 100 according to an embodiment of this application. FIG. 7A is a top view of the die 100, and FIG. 7B is a sectional view of the die 100. As shown in FIG. 7A and FIG. 7B, the die 100 includes a substrate 110, a first bus signal board 120, a first metal plate 130, and a transistor 140. The first bus signal board 120, the first metal plate 130, and the transistor 140 are all stacked on the substrate 110.

Specifically, the first bus signal board 120 and the first metal plate 130 are spaced apart in a Z-axis direction (or referred to as a "first direction"). For example, the Z-axis direction may be a thickness direction of the substrate 110, and the Z-axis direction, an X-axis direction, and a Y-axis direction are perpendicular to each other. In the Z-axis direction, a projection region of the first bus signal board 120 on the substrate 110 is a first projection region S1, a projection region of the first metal plate 130 on the substrate 110 is a second projection region S2, and the first projection region S1 and the second projection region S2 at least partially overlap.

In this way, the first bus signal board 120 and the first metal plate 130 may jointly form a capacitor (for example, a capacitor C2), to form various circuits (for example, the foregoing second matching circuit M2) based on different needs. Different capacitance values may be obtained by adjusting a size of an overlapping region between the first projection region S1 and the second projection region S2, to meet working requirements in different application scenarios. For example, the second projection region S2 may be located in the first projection region S1. In this way, different capacitance values may also be designed by adjusting a size of the second projection region S2.

The first bus signal board 120 and the first metal plate 130 are separately connected to pins (not marked) of the transistor 140. In the Z-axis direction, a projection region of the transistor 140 on the substrate 110 is a third projection region S3, and the third projection region S3 and the first projection region S1 are spaced apart from each other.

According to the die 100, a layout of the first bus signal board 120 and the first metal plate 130 is properly designed, so that area reusing is also implemented between the first bus signal board 120 and the first metal plate 130 when a circuit design requirement is met, to effectively avoid that the capacitor C2 occupies an extra area of the substrate 110, thereby improving a space utilization rate of the die 100, and reducing manufacturing costs of the die 100.

For example, in comparison with FIG. 6 and FIG. 7A, the capacitor is also integrated into the die, but the capacitor C2 in the die 100b additionally occupies the area of the substrate 110b. As a result, the die 100b has an excessively large overall area, a low space utilization rate, and high manufacturing costs. However, in this application, the first metal plate 130 and the first bus signal board 120 share a part of an area, to effectively avoid that the capacitor C2 additionally occupies the area of the substrate 110, so that the die 100 has a more compact overall structure, a higher space utilization rate, and lower manufacturing costs.

In addition, in comparison with the solution in which two metal plates (that is, the first plate 150b and the second plate 160b) are added to the die 100b to form the capacitor C2, according to the die 100 in this application, the original first bus signal board 120 and the added first metal plate 130 are used to jointly form the capacitor C2, to effectively reduce an unnecessary component, thereby further improving the space utilization rate of the die 100, and reducing the manufacturing costs.

Still refer to FIG. 7B. In some embodiments of this application, the substrate 110 may include a substrate layer 111 and a semiconductor layer 112 that are stacked in the Z-axis direction. The semiconductor layer 112 may be any one of gallium nitride, gallium arsenide (Gallium arsenide, GaAs), or a laterally-diffused metal-oxide semiconductor (Laterally-diffused metal-oxide semiconductor, LDMOS).

In some embodiments of this application, a dielectric layer 150 may be arranged between the first bus signal board 120 and the first metal plate 130 in the Z-axis direction. Different capacitance values may be designed by adjusting a thickness of the dielectric layer 150, to adapt to different application scenarios. The thickness of the dielectric layer 150 is a size of the dielectric layer 150 in the Z-axis direction. For example, the dielectric layer 150 may be made of a material like silicon nitride (for example, Si₃N₄ or Si₂N₃) or aluminum oxide (Al₂O₃).

In some embodiments of this application, both the first metal plate 130 and the transistor 140 are located on a same surface of the substrate 110. The first bus signal board 120 is located on a side that is of the first metal plate 130 and that faces away from the substrate 110. In this way, the first metal plate 130 and the transistor 140 can also be conveniently manufactured on the substrate 110 at a time when it is ensured that the first bus signal board 120 and the first metal plate 130 can jointly form the capacitor C2, thereby effectively reducing molding difficulty and manufacturing costs of the first metal plate 130 and the transistor 140.

Still refer to FIG. 7A. In some embodiments of this application, the transistor 140 may be a field-effect transistor. The transistor 140 includes at least one gate finger 141, at least one source region 142, and at least one drain finger 143. The gate finger 141 is a metal finger of a gate in the transistor 140. The source region 142 is a metal strip of a source in the transistor 140. The drain finger 143 is a metal finger of a drain in the transistor 140.

In some embodiments of this application, a plurality of gate fingers 141, a plurality of source regions 142, and a plurality of drain fingers 143 may be provided, to meet a use requirement in a high-power scenario, thereby further expanding an application scope of the die 100. For example, the plurality of gate fingers 141, the plurality of source regions 142, and the plurality of drain fingers 143 extend in the X-axis direction. In the Y-axis direction, the plurality of source regions 142 and the plurality of drain fingers 143 are alternately arranged, and each gate finger 141 is located between a source region 142 and a drain finger 143 that are in one group and that are adjacent to the gate finger 141.

The first bus signal board 120 may be used as an input bus signal board, and is connected to the plurality of gate fingers 141 of the transistor 140. An input end signal may be split to the gate fingers 141 through the first bus signal board 120. The plurality of gate fingers 141 may also be connected to another element (for example, a switch or a duplexer) or a package through the first bus signal board 120.

The first metal plate 130 and the transistor 140 are spaced apart in the X-axis direction. In some embodiments of this application, projections of the plurality of gate fingers 141 of the transistor 140 are located in a projection of the first metal plate 130 in the X-axis direction, to ensure that a distance between the capacitor C2 including the first bus signal board 120 and the first metal plate 130 and the plurality of gate fingers 141 is not excessively long, so that a working effect of the capacitor C2 is better, thereby further improving working performance of the die 100.

In comparison with FIG. 6 and FIG. 7A, the capacitor C2 in the die 100b is located on a side of the transistor 140b. As a result, a distance between the capacitor C2 and a middle gate finger 141b is longer, and an effect of controlling secondary harmonic impedance of the gate finger 141b is affected, resulting in poorer performance of the die 100b. However, in this application, a layout of the plurality of gate fingers 141 is properly arranged, to effectively avoid an excessively long distance between the plurality of gate fingers 141 and the capacitor C2, thereby improving the working performance of the die 100 when a high-power use requirement is met.

Still refer to FIG. 7A. The first metal plate 130 may be connected to any one or more of the source regions 142 of the transistor 140 through a metal trace 160. For example, the source region 142 includes a first source region 142', a second source region 142", a third source region 142"', and a fourth source region 142"". The metal trace 160 includes a first metal trace 161, a second metal trace 162, a third metal trace 163, and a fourth metal trace 164. The first source region 142', the second source region 142", the third source region 142"', and the fourth source region 142'''' are connected to the first metal plate 130 through the first metal trace 161, the second metal trace 162, the third metal trace 163, and the fourth metal trace 164 respectively.

In some embodiments of this application, the metal trace 160 may be equivalent to an inductor. Different inductance values may be designed by adjusting a length and a width of the metal trace 160 and a quantity of metal traces 160, to adapt to different application scenarios. The length of the metal trace 160 is a size of the metal trace 160 in the X-axis direction. The width of the metal trace 160 is a size of the metal trace 160 in the Y-axis direction. Inductors with different inductance values may be configured to form various circuits (for example, a second matching circuit M2), to meet different working requirements.

For ease of description, the following describes, by using the first metal trace 161 in the metal trace 160 as an example, a specific structure and an arrangement manner when the metal trace 160 is equivalent to the inductor.

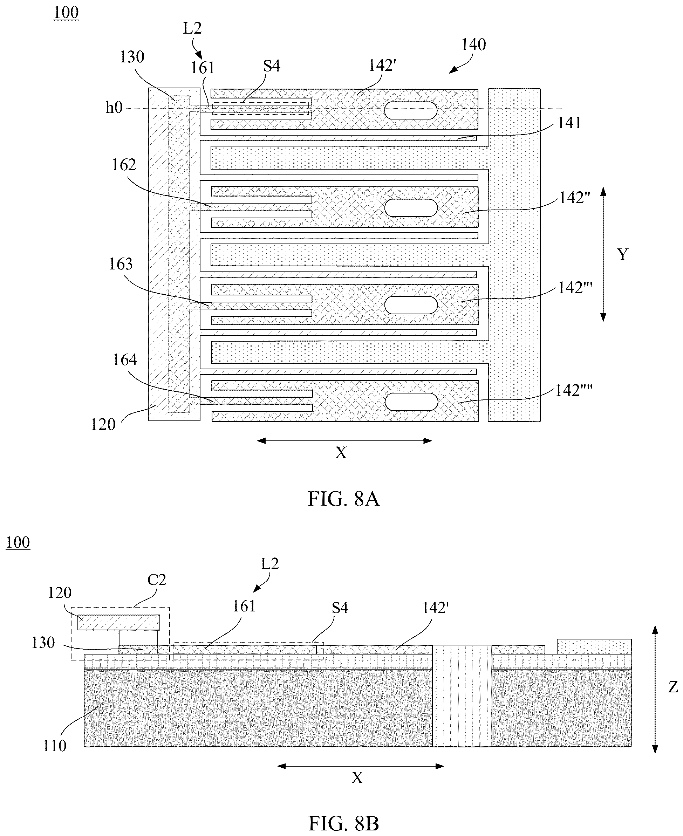

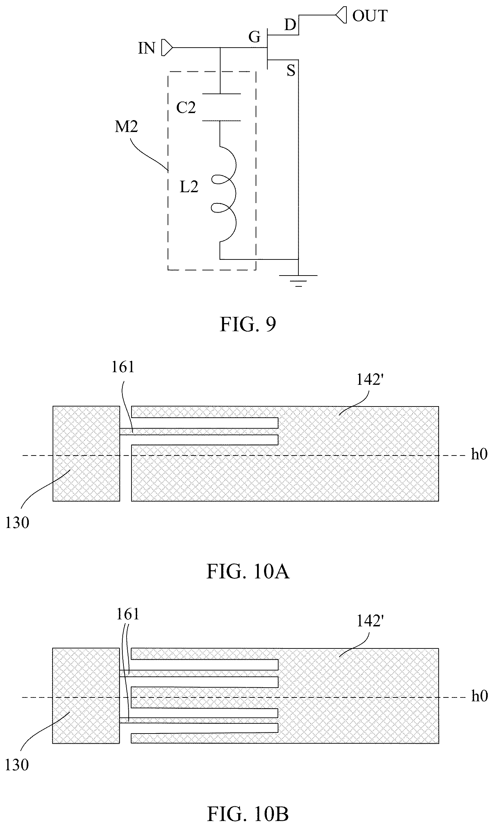

FIG. 8A and FIG. 8B are diagrams of a structure of the die 100 when the first metal trace 161 in the die 100 is equivalent to an inductor L2 according to some embodiments of this application. FIG. 8A is a top view of the die 100, and FIG. 8B is a sectional view of the die 100. FIG. 9 is a circuit diagram of the second matching circuit M2 including the inductor L2 and the capacitor C2 in the die 100 according to an embodiment of this application.

Refer to FIG. 8A to FIG. 9. The first metal trace 161 in the die 100 has a specific length and width. Therefore, the first metal trace 161 may be equivalent to the inductor L2. The first bus signal board 120 and the first metal plate 130 may jointly form the capacitor C2. The inductor L2 and the capacitor C2 jointly form the second matching circuit M2. Specifically, a first end of the capacitor C2 is connected between an input end IN and a gate G of the die 100, and a second end of the capacitor C2 is connected to a source S of the die 100 through the inductor L2 and is grounded, to form the second matching circuit M2. A drain D of the die 100 is connected to an output end OUT.

To avoid that the first metal trace 161 occupies an extra area of the substrate 110 when ensuring that the first metal trace 161 has an appropriate size and quantity, in some embodiments of this application, area reusing can be implemented between the first metal trace 161 and another component (for example, the transistor 140), to further improve the space utilization rate of the die 100, reduce the manufacturing costs, and expand the application scope.

Specifically, a projection of the first metal trace 161 and a projection of the first source region 142' at least partially overlap in the X-axis direction. In this way, size reusing may be implemented between the first metal trace 161 and the first source region 142' in the Y-axis direction, to effectively avoid that the first metal trace 161 occupies an excessive area when ensuring that the first metal trace 161 has a specific width, thereby further improving the space utilization rate, and reducing the manufacturing costs. For example, the first metal trace 161 may extend in the X-axis direction. In addition, the projection of the first metal trace 161 is located in the projection of the first source region 142' in the X-axis direction, to further reduce an area of the die 100, thereby improving the space utilization rate.

Alternatively, in some other alternative implementations, size reusing may alternatively be implemented between the first metal trace 161 and the first source region 142' in the X-axis direction. Specifically, the projection of the first metal trace 161 and the projection of the first source region 142' at least partially overlap in the Y-axis direction, to effectively avoid that the first metal trace 161 occupies an excessive area when ensuring that the first metal trace 161 has a specific length. For example, a projection region of a first part S4 of the first metal trace 161 is located in a projection region of the first source region 142' in the Y-axis direction. The first part S4 of the first metal trace 161 may be formed by performing graphical (for example, groove) design on the first source region 142'.

In some embodiments of this application, the first metal trace 161 may be symmetrically arranged relative to a central axis h0 of the first source region 142'. The central axis h0 of the first source region 142' is a straight line that passes through a midpoint of the first source region 142' and that is parallel to the X-axis direction.

Alternatively, in some other embodiments, the first metal trace 161 may alternatively be arranged at another position. For example, FIG. 10A and FIG. 10B show example arrangement manners of the first metal trace 161 according to some embodiments of this application. As shown in FIG. 10A, the first metal trace 161 may alternatively be arranged on a side of the central axis h0 of the first source region 142'. Still as shown in FIG. 10B, two first metal traces 161 may alternatively be provided. The two first metal traces 161 may be respectively arranged on two sides of the central axis h0 of the first source region 142'. This is not limited in this application. Any layout form of the first metal trace 161 that can implement area reusing between the first source region 142' and the first metal trace 161 falls within the protection scope of this application.

In some embodiments of this application, a ratio of the length of the first metal trace 161 to a length of the first source region 142' may range from 0.1 to 0.7, for example, may be 0.1, 0.2, or 0.3. In this way, the first source region 142' can also work normally when it is ensured that the first metal trace 161 has a specific length and can be equivalent to the inductor. The length of the first source region 142' is a size of the first source region 142' in the X-axis direction.

It may be understood that, the foregoing embodiments are described by using only an example in which the first metal plate 130 is connected to the first source region 142' through the first metal trace 161. For a specific manner of connecting the first metal plate 130 to the another source region 142, refer to the foregoing manner of connecting the first metal plate 130 to the first source region 142'.

For example, the first metal plate 130 is connected to the second source region 142 through the second metal trace 162. A projection of the second metal trace 162 and a projection of the second source region 142" at least partially overlap in the X-axis direction, and the projection of the second metal trace 162 and the projection of the second source region 142" at least partially overlap in the Y-axis direction, to implement area reusing between the second metal trace 162 and the second source region 142".

Correspondingly, for specific manners of connecting the first metal plate 130 to the third source region 142"' and the fourth source region 142"", refer to the manners of connecting the first metal plate 130 to the first source region 142' in FIG. 8A, FIG. 10A, and FIG. 10B. For details, refer to the foregoing related descriptions. Details are not described herein again.

Still refer to FIG. 7A. In some embodiments of this application, a ground hole 1421 is further provided on each of the source regions 142 of the transistor 140. The ground hole 1421 can be connected to the source region 142 and the bottom (that is, a ground plane) of the die 100, so that the source regions 142 are grounded.

In some embodiments of this application, the die 100 may further include a second bus signal board (used as an output bus signal board) 170. The second bus signal board 170 is connected to the plurality of drain fingers 143 of the transistor 140. Based on this, signals on the plurality of drain fingers 143 may be separately combined to the second bus signal board 170, and may be output through the second bus signal board 170. For example, the plurality of drain fingers 143 may also be connected to another element (for example, a switch or a duplexer) or a package through the second bus signal board 170.

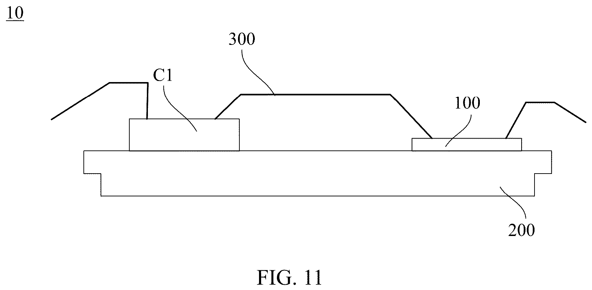

This application further provides a chip 10. The chip 10 includes at least one die 100. FIG. 11 is a diagram of a structure of a chip 10 including a die 100 according to an embodiment of this application. Refer to FIG. 8A to FIG. 9 and FIG. 11. The chip 10 includes the die 100, a capacitor C1, and a base board 200. The die 100 and the capacitor C1 are separately arranged on the base board 200. The capacitor C1 is connected to the die 100 through a bonding wire 300. The capacitor C1 and the bonding wire 300 may form a first matching circuit M1 configured to adjust fundamental impedance. A capacitor C2 and an inductor L2 inside the die 100 may form a second matching circuit M2 configured to adjust secondary harmonic impedance.

According to the chip 10, the capacitor C2 and the inductor L2 inside the die 100 form the second matching circuit M2, to better adjust a phase of the secondary harmonic impedance to 180°, thereby further improving efficiency of the chip 10, and reducing energy consumption. In addition, a requirement for adjusting impedance of the chip 10 can be met by arranging only the capacitor C1, the die 100, and the bonding wire 300 inside the chip 10, to effectively reduce an unnecessary electronic component, thereby improving a space utilization rate inside the chip 10, and reducing manufacturing costs. For example, in a chip 10a shown in FIG. 3, to meet a requirement for adjusting impedance, a capacitor C1, a capacitor C2, a die 100a, a bonding wire 300a, and a bonding wire 400a, five components in total, need to be arranged. However, in this application, only the capacitor C1, the die 100, and the bonding wire 300, three components in total, need to be arranged. Compared with the chip 10a, two components are reduced, and an overall structure is more compact, so that an application scope is wider.

In addition, to ensure an effect of adjusting the impedance, the bonding wire 300a and the bonding wire 400a in the chip 10a need to have specific lengths, resulting in large parasitic inductance, and affecting the effect of adjusting the impedance. Especially in a high-frequency application scenario, impact on the effect of adjusting the impedance is more apparent. However, in this application, the capacitor C2 and the inductor L2 inside the die 100 form the second matching circuit M2, and only the bonding wire 300 connecting the capacitor C1 to the die 100 is reserved. This effectively reduces a quantity of bonding wires, and reduces parasitic inductance between the bonding wires, thereby further improving working performance of the chip 10.

It should be noted that, this embodiment is an example for descriptions of the technical solutions of this application, and a person skilled in the art may make other variations. For example, in this embodiment, only an example in which the capacitor C2 and the inductor L2 in the die 100 form the second matching circuit M2 is used for description. In some other embodiments, the capacitor C2 and the inductor L2 inside the die 100 may alternatively form another circuit, for example, a first matching circuit M1.

For another example, in this embodiment, a first bus signal board 120 and a first metal plate 130 of the die 100 may jointly form the capacitor C2, and a metal trace 160 may be equivalent to the inductor L2. In some other embodiments, in the die 100, more capacitors or inductors may also be formed by using another component, to form another circuit. For example, area reusing may also be implemented between a second bus signal board 170 of the die 100 and another metal plate, to joint form a capacitor.

For another example, this embodiment is described by using an example in which a transistor 140 is a field-effect transistor. In some other embodiments, the transistor 140 may alternatively be another type of transistor instead of the field-effect transistor. For example, the transistor 140 may alternatively be a diode, a triode, or a thyristor.

The foregoing describes implementations of this application in specific embodiments, and other advantages and effects of this application may be readily understood by a person skilled in the art from content disclosed in this specification. Although this application is described with reference to some embodiments, it does not mean that a characteristic of this application is limited only to this implementation. On the contrary, a purpose of describing this application with reference to an implementation is to cover another option or modification that may be derived based on claims of this application. This application may alternatively be implemented without using these details. In addition, to avoid confusion or blurring a focus of this application, some specific details are omitted from the descriptions. It should be noted that, embodiments in this application and the features in embodiments may be mutually combined in the case of no conflict.

In the descriptions of this application, it should be noted that, directions or position relationships indicated by terms such as "center", "up", "down", "left", "right", "vertical", "horizontal", "outside", "inside", "a circumferential direction", "a radical direction", and "an axial direction" are based on the directions or position relationships shown in the accompanying drawings, and are only intended to describe this application and simplify the descriptions, but are not intended to indicate or imply that an indicated apparatus or element needs to have a specific direction or be constructed and operated in a specific direction, and therefore cannot be understood as a limitation on this application.

In the descriptions of this application, it should be noted that, unless otherwise explicitly specified and limited, terms such as "arrange", "mount", "connect", and "attach" should be understood in a broad sense. For example, such terms may indicate a fixed connection, a detachable connection, or an integral connection, may indicate a mechanical connection or an electrical connection, and may indicate a direct connection, an indirect connection through an intermediate medium, or an internal communication between two elements. A person of ordinary skill in the art may understand specific meanings of the foregoing terms in this application based on specific situations.

It is clearly that a person skilled in the art can make various modifications and variations to this application without departing from the spirit and scope of this application. This application is intended to cover the modifications and variations of this application provided that they fall within the scope of protection defined by the following claims and their equivalent technologies.

## Claims

1. A die, comprising a substrate, and a first bus signal board, a first metal plate, and a transistor that are stacked on the substrate, wherein
the first bus signal board and the first metal plate are spaced apart in a first direction, and the first direction is a thickness direction of the substrate; and in the first direction, a projection region of the first bus signal board on the substrate is a first projection region, a projection region of the first metal plate on the substrate is a second projection region, and the first projection region and the second projection region at least partially overlap; and
in the first direction, a projection region of the transistor on the substrate is a third projection region, and the third projection region and the first projection region are spaced apart from each other; and the first bus signal board and the first metal plate are separately connected to pins of the transistor.

2. The die according to claim 1, wherein the second projection region is located in the first projection region.

3. The die according to claim 1, wherein a dielectric layer is arranged between the first bus signal board and the first metal plate in the first direction.

4. The die according to claim 3, wherein the dielectric layer comprises silicon nitride or aluminum oxide.

5. The die according to claim 1, wherein the first metal plate and the transistor are located on a same surface of the substrate, and the first bus signal board is located on a side that is of the first metal plate and that faces away from the substrate.

6. The die according to any one of claims 1 to 5, wherein the transistor is a field-effect transistor.

7. The die according to claim 6, wherein the first bus signal board is an input bus signal board, and the input bus signal board is connected to a gate finger of the transistor; and
the transistor comprises at least one source region, the at least one source region comprises a first source region, and the first metal plate is connected to the first source region through a first metal trace.

8. The die according to claim 7, wherein the first metal plate and the transistor are spaced apart in a second direction, and the second direction is perpendicular to the first direction; and
the first source region extends in the second direction, and a projection of the first metal trace and a projection of the first source region at least partially overlap in the second direction.

9. The die according to claim 8, wherein the first metal trace extends in the second direction, the projection of the first metal trace is located in the projection of the first source region in the second direction, a projection of the first metal trace and a projection of the first source region at least partially overlap in a third direction, and the third direction is perpendicular to both the first direction and the second direction.

10. The die according to claim 9, wherein the at least one source region further comprises a second source region, and the first metal plate is connected to the second source region through a second metal trace; and
the second source region extends in the second direction, and the second source region and the first source region are spaced apart in the third direction, wherein a projection of the second metal trace and a projection of the second source region at least partially overlap in the second direction, and a projection of the second metal trace and a projection of the second source region at least partially overlap in the third direction.

11. The die according to claim 7, wherein each of the at least one source region is grounded.

12. The die according to claim 7, wherein there are a plurality of gate fingers of the transistor, the plurality of gate fingers extend in a second direction, the plurality of gate fingers are spaced apart in a third direction, the first direction, the second direction, and the third direction are perpendicular to each other, and the plurality of gate fingers are separately connected to the first bus signal board; and projections of the plurality of gate fingers are located in a projection of the first metal plate in the second direction.

13. The die according to claim 7, wherein the die further comprises an output bus signal board, and the output bus signal board is connected to a drain finger of the transistor.

14. A chip, comprising a base board and the die according to any one of claims 1 to 13, wherein the die is arranged on the base board.

15. The chip according to claim 14, wherein the chip is a power amplifier chip.

16. An electronic device, comprising a housing and the chip according to claim 14 or 15, wherein the chip is arranged in the housing.
